# EUROPEAN PATENT APPLICATION

(11) **EP 4 852 055 A1**
(43) Date of publication of application: **09.12.2026**
(21) Application number: 24922165.6
(22) Date of filing: 02.02.2024
(51) Int. Cl.: H01L 23/12

(54) **ABLATION PROCESSING METHOD, ABLATION PROCESSING DEVICE, AND SUBSTRATE**

(71) Applicant: Shin-Etsu Engineering Co., Ltd., Tokyo 101-0054 (JP)
(72) Inventor: OHTANI, Yoshikazu, Annaka-shi, Gunma 379-0127 (JP); TOMIOKA, Kyouhei, Annaka-shi, Gunma 379-0127 (JP); SUZUKI, Tomoya, Annaka-shi, Gunma 379-0127 (JP); YAMAOKA, Hiroshi, Yokohama-shi, Kanagawa 234-0053 (JP); USAMI, Taketo, Yokohama-shi, Kanagawa 234-0053 (JP); KURATA, Masami, Yokohama-shi, Kanagawa 234-0053 (JP)
(74) Representative: Meissner Bolte Partnerschaft mbB
(86) International application number: PCT/JP2024/003543
(87) International publication number: WO 2025/163906

(57) **Abstract**

The present invention is an ablation processing method for forming a processed recessed portion on a surface of a substrate through ablation processing using irradiation energy of a laser beam, and the ablation processing is performed such that an angle formed by a sidewall surface of the processed recessed portion on an opening side of the processed recessed portion and the surface of the substrate is 80° or more and 90° or less. Accordingly, a substrate for use in a semiconductor package substrate that enables densification and reduction in wiring resistance and exhibits high performance can be provided.

## Description

### TECHNICAL FIELD

The present invention relates to an ablation processing method, an ablation processing apparatus, and a substrate.

### BACKGROUND ART

Semiconductor package substrates have been actively developed in line with a trend from "More Than Moore" to a system on a chip (SoC) in which a system is integrated into one chip. In addition, the configurations of semiconductor package substrates have become more complex and denser.

Regarding formation of a circuit pattern of a printed wiring substrate, for example, Patent Document 1 discloses a printed-wiring-substrate manufacturing method including curing an uncured resin layer on a substrate while pressing a relief printing plate against a surface of the uncured resin layer, peeling the relief printing plate from the cured resin layer on the substrate to form a groove portion in a surface of the resin layer, and filling the groove portion with a conductor paste to form conductor wiring.

In addition, Patent Document 2 discloses forming a via-wiring-forming via by a photolithography process, the via-wiring-forming via being a hole for forming via wiring.

### CITATION LIST

### PATENT LITERATURE

Patent Document 1: Japanese Patent Laid-open Publication No. 2004-253432
Patent Document 2: Japanese Patent Laid-open Publication No. 2020-087981

### SUMMARY OF INVENTION

### TECHNICAL PROBLEM

The configurations of semiconductor package substrates have continued to become more complex and denser, and further densification is desired. At the same time, a reduction in wiring resistance of metal wiring formed by filling metal into through-holes, recessed portions, and the like formed in a semiconductor package substrate is also desired. However, since wiring resistance increases when a pattern becomes high-definition, processing having a deep processing depth and a wide width extending to a lower portion is required to prevent the increase. With methods for forming recessed portions as disclosed in Patent Documents 1 and 2, the accuracy of recessed portion formation is low, densification and reduction in wiring resistance are insufficient, and performance improvement could not be expected.

The present invention has been made to solve the above-described problems, and an objective of the present invention is to provide a substrate for use in a semiconductor package substrate that enables densification and reduction in wiring resistance, and an ablation processing method and an ablation processing apparatus that are capable of processing recessed portions included in the substrate and have high performance.

### SOLUTION TO PROBLEM

The present invention has been made to achieve the above-described objective and provides an ablation processing method for forming a processed recessed portion on a surface of a substrate through ablation processing using irradiation energy of a laser beam, in which the ablation processing is performed such that an angle formed by a sidewall surface of the processed recessed portion on an opening side of the processed recessed portion and the surface of the substrate is 80° or more and 90° or less.

With such an ablation processing method, high-accuracy processing is enabled, and a substrate for use in a semiconductor package substrate that enables densification and reduction in wiring resistance can be provided.

In the ablation processing method, energy density of the laser beam with which a processed portion of the substrate is irradiated may be set to 1.0 [J/cm²] or more.

Accordingly, a substrate for use in a semiconductor package substrate that more easily and stably enables densification and reduction in wiring resistance and exhibits high performance can be provided.

In the ablation processing method, an irradiation size of the laser beam may be reduced by passing the laser beam through a reduced projection optical lens having an NA of 0.12 or more.

Accordingly, higher-accuracy processing is enabled, and a substrate for use in a semiconductor package substrate that more easily enables densification and reduction in wiring resistance and exhibits high performance can be provided.

In the ablation processing method, an irradiation size of the laser beam may be adjusted by passing the laser beam through a mask, the laser beam may be set at a fixed position, the laser beam may be swept relative to a pattern area of the mask by performing a sweep operation while synchronizing the mask and a substrate stage on which the substrate is placed, and ablation processing having a size larger than the irradiation size of the laser beam may be performed, thereby forming the processed recessed portion.

Accordingly, a substrate for use in a semiconductor package substrate that more easily and stably enables densification and reduction in wiring resistance and exhibits high performance can be provided.

The present invention has also been made to achieve the above-described objective and provides an ablation processing apparatus for forming a processed recessed portion on a surface of a substrate through ablation processing using irradiation energy of a laser beam, the ablation processing apparatus including: a first optical function unit including a laser light source that emits the laser beam; a substrate stage on which the substrate is placed; and a control unit that controls the ablation processing apparatus, in which the control unit controls execution of the ablation processing such that an angle formed by a sidewall surface of the processed recessed portion on an opening side of the processed recessed portion and the surface of the substrate is 80° or more and 90° or less.

With such an ablation processing apparatus, high-accuracy processing is enabled, and a substrate for use in a semiconductor package substrate that enables densification and reduction in wiring resistance can be manufactured.

In the ablation processing apparatus, the control unit may set energy density of the laser beam with which a processed portion of the substrate is irradiated to 1.0 [J/cm²] or more.

Accordingly, a substrate for use in a semiconductor package substrate that more easily and stably enables densification and reduction in wiring resistance and exhibits high performance can be provided.

The ablation processing apparatus may further include a reduced projection optical lens having an NA of 0.12 or more, in which an irradiation size of the laser beam may be reduced by passing the laser beam through the reduced projection optical lens.

Accordingly, higher-accuracy processing is enabled, and a substrate for use in a semiconductor package substrate that more easily enables densification and reduction in wiring resistance and exhibits high performance can be provided.

The ablation processing apparatus may further include a mask that adjusts a beam shape of the laser beam when the laser beam passes through the mask, in which the control unit may set the laser beam at a fixed position, sweep the laser beam relative to a pattern area of the mask by performing a sweep operation while synchronizing the mask and the substrate stage, and perform ablation processing having a size larger than the irradiation size of the laser beam, thereby forming the processed recessed portion.

Accordingly, a substrate for use in a semiconductor package substrate that more easily and stably enables densification and reduction in wiring resistance and exhibits high performance can be provided.

The present invention has also been made to achieve the above-described objective and provides a substrate for use in a semiconductor package substrate, in which the substrate has at least one recessed portion on a surface of the substrate, and an angle formed by a sidewall surface of the recessed portion on an opening side of the recessed portion and the surface of the substrate is 80° or more and 90° or less.

According to such a substrate, a substrate for use in a semiconductor package that enables densification and reduction in wiring resistance and has high performance is provided.

### ADVANTAGEOUS EFFECTS OF INVENTION

As described above, according to an ablation processing method of the present invention, high-accuracy processing is enabled, and a substrate for use in a semiconductor package substrate that enables densification and reduction in wiring resistance can be manufactured.

In addition, according to an ablation processing apparatus of the present invention, high-accuracy processing is enabled, and a substrate for use in a semiconductor package substrate that enables densification and reduction in wiring resistance can be manufactured.

According to a substrate of the present invention, a substrate for use in a semiconductor package substrate that enables densification and reduction in wiring resistance and exhibits high performance is provided.

### BRIEF DESCRIPTION OF DRAWINGS

[FIG. 1] is a schematic sectional view illustrating an example of a substrate for use in a semiconductor package substrate of the present invention;
[FIG. 2] is a schematic view illustrating an example of an ablation processing apparatus of the present invention;
[FIG. 3] is a schematic view illustrating an example of laser irradiation in an ablation processing method of the present invention;
[FIG. 4] is a schematic view illustrating out-of-focus laser irradiation in FIG. 3;
[FIG. 5] is a schematic view illustrating an example of the ablation processing method of the present invention;
[FIG. 6] is a schematic view illustrating another example of laser irradiation in the ablation processing method of the present invention;
[FIG. 7] is a schematic sectional view illustrating an example of processed recessed portions that can be formed by the ablation processing method of the present invention; and
[FIG. 8] is intensity distribution of an example of laser that can be used in the ablation processing method of the present invention.

### DESCRIPTION OF EMBODIMENTS

As described above, there has been a demand for providing a substrate for use in a semiconductor package that enables densification and reduction in wiring resistance and has high performance, and an ablation processing method and an ablation processing apparatus that are capable of processing recessed portions included in the substrate.

As a result of extensive studies on the above-described problems, the inventors found that, when ablation processing using irradiation energy of a laser beam is performed, high-accuracy processing is enabled, and a substrate provided with a processed recessed portion in which an angle formed by a sidewall surface of the processed recessed portion on an opening side of the processed recessed portion and the surface of the substrate is 80° or more and 90° or less can be obtained, which has led to completion of the present invention.

Specifically, the present invention is an ablation processing method for forming a processed recessed portion on a surface of a substrate through ablation processing using irradiation energy of a laser beam, and the ablation processing is performed such that an angle formed by a sidewall surface of the processed recessed portion on an opening side of the processed recessed portion and the surface of the substrate is 80° or more and 90° or less.

The present invention is also an ablation processing apparatus for forming a processed recessed portion on a surface of a substrate through ablation processing using irradiation energy of a laser beam, the ablation processing apparatus including: a first optical function unit including a laser light source that emits the laser beam; a substrate stage on which the substrate is placed; and a control unit that controls the ablation processing apparatus, and the control unit controls execution of the ablation processing such that an angle formed by a sidewall surface of the processed recessed portion on an opening side of the processed recessed portion and the surface of the substrate is 80° or more and 90° or less.

The present invention is also a substrate for use in a semiconductor package substrate, the substrate has at least one recessed portion on a surface of the substrate, and an angle formed by a sidewall surface of the recessed portion on an opening side of the recessed portion and the surface of the substrate is 80° or more and 90° or less.

The present invention will be described below in detail, but the present invention is not limited thereto. Note that, in the present specification, a "recessed portion" and a "processed recessed portion" include not only a recessed structure having a bottom surface but also a so-called through-hole having no bottom surface.

### [Substrate]

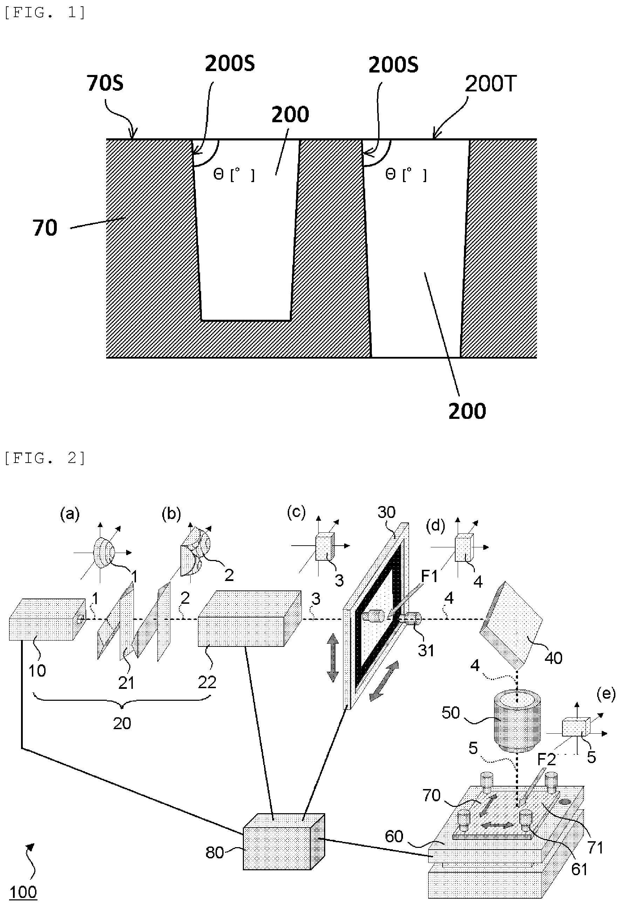

FIG. 1 is a schematic view illustrating an example of a substrate for use in a semiconductor package substrate of the present invention. A substrate 70 for use in a semiconductor package substrate illustrated in FIG. 1 has at least one recessed portion 200 on a surface of the substrate. The substrate 70 is also a substrate in which an angle (θ) formed by a sidewall surface 200S of the recessed portion 200 on an opening side of the recessed portion 200 and a surface 70S of the substrate is 80° or more and 90° or less. In another aspect, an angle (θ) formed by an opening end 200T of the recessed portion 200 parallel to the surface 70S of the substrate 70 and the sidewall surface 200S of the recessed portion is 80° or more and 90° or less. With such a substrate 70, both densification and reduction in resistance of metal wiring can be achieved, and performance improvement is possible. The lower limit value of the above-described angle (θ) may be preferably 83° or more, and more preferably 85° or more.

The material and the like of the substrate 70 are not particularly limited. The substrate 70 may be a substrate or a laminate including at least one of ceramic, resin, a semiconductor, metal, and the like.

The substrate of the present invention is a substrate for use in a semiconductor package substrate that enables densification and reduction in wiring resistance and exhibits high performance.

### [Ablation Processing Apparatus]

The ablation processing apparatus according to the present invention is capable of manufacturing the above-described substrate for use in a semiconductor package substrate of the present invention. FIG. 2 is a schematic view illustrating an example of the ablation processing apparatus of the present invention. An ablation processing apparatus 100 illustrated in FIG. 2 is an apparatus for forming a processed recessed portion (including a through-hole) in the substrate 70 by using laser. Note that the ablation processing apparatus 100 illustrated in FIG. 2 indicates an example of the ablation processing apparatus of the present invention, and the ablation processing apparatus of the present invention is not limited to the apparatus illustrated in FIG. 2.

The ablation processing apparatus 100 according to the present invention includes a first optical function unit 20 including a laser light source 10 that emits laser beam 1, a substrate stage 60 on which the substrate 70 is placed, and a control unit 80 that controls the ablation processing apparatus 100. The control unit 80 controls execution of the ablation processing such that an angle formed by the sidewall surface of the processed recessed portion on the opening side of the processed recessed portion and the surface of the substrate is 80° or more and 90° or less.

The ablation processing apparatus according to the present invention including such a control unit 80 can form high-density processed recessed portions such as VIAs and trenches in processing of a semiconductor package substrate or the like and can perform recessed-portion-forming processing with a high aspect ratio, and thus can form processed recessed portions such as deep VIAs and trenches. Accordingly, the ablation processing apparatus can manufacture a semiconductor package substrate that enables densification and reduction in the resistance value of metal wiring embedded in the processed recessed portions and exhibits high performance.

The structure, the material, and the like of the substrate stage 60 are not particularly limited as long as the substrate stage 60 is capable of holding the substrate 70.

The first optical function unit 20 includes the laser light source 10 that emits laser beam 1. The laser light source 10 may be, for example, a laser light source (laser oscillator) 10 that emits (outputs) laser beam 1 in pulses. More specifically, the laser light source 10 may include an excimer laser oscillator. Use of the excimer laser enables efficient processing of an object to be processed that is made of an organic material, such as an ABF substrate, and enables high-productivity processing. In addition, since the excimer laser has low coherence, use of the excimer laser can achieve extremely uniform beam formation.

In addition, the excimer laser enables adjustment of processing depth with higher accuracy and adjustment of the width of a recessed portion and/or a through-hole with higher accuracy than a solid laser. In particular, the excimer laser is useful for forming recessed portions such as blind holes and trenches. Thus, use of the excimer laser enables high-accuracy processing of a complex protrusion-recess shape such as a circuit board.

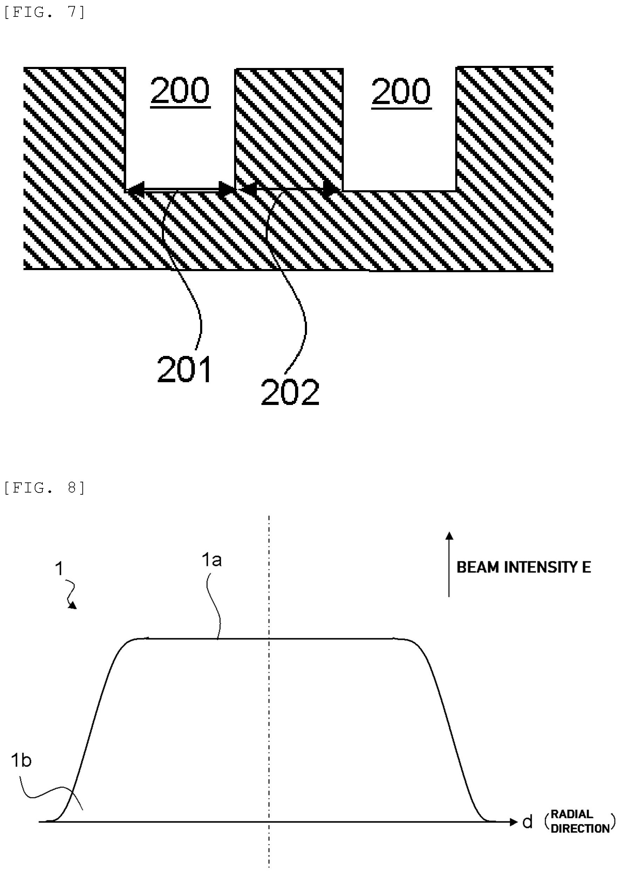

Note that the irradiation shape of laser beam 1 oscillated by the laser light source 1 is not particularly limited, and may be an irradiation shape having an intensity distribution in which the laser intensity of a center (inner portion) 1a is highest and the laser intensity of a skirt (outer portion) 1b is low as in an irradiation shape illustrated in FIG. 8, for example, in addition to shapes illustrated in FIGS. 2, 3, and 6.

The first optical function unit 20 may include a prism 21 and a shaping optical system 22 in addition to the laser light source 10 that oscillates laser beam 1. Although details will be described below, the prism 21 is a prism that converts a laser beam having an intensity distribution in which the laser intensity at the center is highest and the laser intensity at the skirt is low into a laser beam having an irradiation shape in which the intensity of an outer portion in the intensity distribution of the laser beam is higher than the intensity of an inner portion, and the shaping optical system 22 is a shaping optical system that converts the irradiation shape of the laser converted by the prism 21 into a top-hat irradiation shape. In the example of the ablation processing apparatus 100 illustrated in FIG. 2, the prism 21 includes a roof prism, but may include a conical prism.

The first optical function unit 20 preferably makes the irradiation shape of laser beam 1, in the above-described manner, into an irradiation shape in which, in the intensity distribution of laser on a surface to be processed of the substrate 70, the intensity of an outer portion in the intensity distribution is higher than the intensity of an inner portion.

As illustrated in FIG. 2, the ablation processing apparatus 100 according to the present invention may further include a mask 30, a folding mirror 40, and a reduced projection optical lens 50 in the stated order from the first optical function unit 20 to the substrate 70 in the optical path of the ablation processing apparatus 100.

The reduced projection optical lens 50 reduces the irradiation size of laser beam 1 when laser beam 1 passes through the reduced projection optical lens 50. Inclusion of such a reduced projection optical lens 50 can enlarge a mask pattern formed on the mask 30 relative to a processing pattern to be actually formed on an object to be processed.

By enlarging the mask pattern formed on the mask 30 relative to the actual processing pattern, energy of laser beam 3 incident on the mask 30 can be made smaller than actual processing energy. When the reduction magnification of the reduced projection optical lens 50 is defined as N, energy of laser incident on a mask surface is 1/(N²) relative to processing energy on a surface of the substrate 70. Accordingly, thermal drift caused by energy of laser beam 3 can be suppressed, and thus thermal expansion of the mask 30 can be suppressed, and high-accuracy processing can be performed even after processing operation for a long time.

In addition, degradation of optical members (for example, the first optical function unit 20 and the mask 30) caused by heat of a laser beam can also be suppressed, and thus the lifetime of the optical members can be extended.

The reduced projection optical lens 50 may include a pair of reduced projection lenses. When the reduced projection optical lens 50 is an infinity optical system, magnification by the reduced projection optical lens 50 can be adjusted by, for example, the ratio of the focal lengths of the reduced projection lenses and the distance between the reduced projection lenses.

The NA of the reduced projection optical lens 50 is preferably selected in accordance with energy density necessary for processing the substrate 70 and the resolution of processing. The NA of the reduced projection optical lens 50 is preferably 0.12 or more. When the NA of the reduced projection optical lens is 0.12 or more, a laser beam having a high amount of energy can be applied to a processed portion of the substrate, processing with higher resolution can be stably performed, and thus stable recessed-portion processing by fine and high-aspect-ratio ablation processing can be performed. In the present invention, even when laser processing is performed with a high NA for formation at high resolution, a processed recessed portion to be formed can be suppressed from having a tapered shape.

In formation of processed recessed portions such as fine VIAs and trenches in semiconductor package processing, laser beam energy exceeding threshold energy required for ablation to reach an end portion of a processing bottom surface is preferably applied in order to stably perform processing in a state in which an angle (θ°) formed by a wall surface of a processed recessed portion with a laser beam and a plane along a surface of a substrate is close to vertical. For this reason, it is preferable to increase energy density when ablation processing with laser is performed. Thus, the control unit 80 preferably sets energy density of laser beam 1 with which a processed portion of the substrate 70 is irradiated to 1.0 [J/cm²] or more. Accordingly, the ablation processing apparatus is capable of providing, more easily and stably, a substrate for use in a semiconductor package substrate that enables densification and reduction in wiring resistance.

In addition, it is preferable that the ablation processing apparatus 100 according to the present invention include the mask 30 as described above, and that the control unit 80 set laser beam 1 at a fixed position, sweep laser beam 1 relative to a pattern area of the mask 30 by performing a sweep operation while synchronizing the mask 30 and the substrate stage 60 on which the substrate 70 is placed, and perform ablation processing having a size larger than the irradiation size of laser beam 1, thereby forming a processed recessed portion.

By performing the sweep operation while synchronizing the mask and the substrate stage, the aperture size of the reduced projection optical lens can be reduced. Unlike a method in which a laser beam is swept while the mask and the substrate stage are fixed, the aperture of the reduced projection optical lens does not need to have a large size, and thus the lens can be prevented from becoming heavy and complex, the lens can be easily made highly accurate, and a high-accuracy product can be manufactured.

Thus, with the apparatus including the mask 30 and the control unit 80, the ablation processing apparatus is capable of even more easily providing a substrate for use in a semiconductor package substrate that enables densification and reduction in wiring resistance.

The ablation processing apparatus 100 of the present invention preferably further includes a temperature adjustment means that adjusts the temperature of the reduced projection optical lens 50. Inclusion of the temperature adjustment means can effectively suppress the influence of heat due to laser energy in the reduced projection optical lens 50. In the reduced projection optical lens 50, laser beam 4 that has passed through the mask 30 is reduced and projected at 1/N, and accordingly, energy of a laser beam passing through a lens portion at an objective distal end is N² times energy of a laser beam with which the mask 30 is irradiated, and thermal influence tends to occur in this portion. Thus, in order to suppress this thermal energy, a temperature adjustment function is provided to the reduced projection optical lens 50, and thus thermal drift caused by energy of a laser beam can be suppressed, and high-accuracy processing can be performed even after processing operation for a long time. In the ablation processing method and the ablation processing apparatus 100 of the present invention, a reduced projection optical lens having an extremely small aperture can be used.

In particular, in a case where a laser beam having a high energy density of 1.0 mJ/cm² or more is used as described above, slight positional shift of irradiation may occur due to a temperature rise caused by the laser beam incident on the reduced projection optical lens, and a processing pattern may be distorted. In order to control heat incident on the reduced projection optical lens as precisely as possible, it is desirable to reduce the aperture diameter of the reduced projection optical lens and to efficiently perform temperature control from a cooling portion by a jacket around the reduced projection lens.

In this manner, the temperature adjustment means for the reduced projection optical lens does not need to be means that can directly provide the temperature adjustment means to the lens. The temperature adjustment means may cool a jacket portion holding the lens. When the lens aperture is large, temperature can be managed in a peripheral portion of the lens, but a temperature adjustment effect is unlikely to reach the vicinity of an important central portion, and thermal management is difficult. Thus, even slight energy absorption into the lens due to laser irradiation for a long time easily causes thermal distortion. When the ablation processing apparatus 100 has a temperature adjustment function for the reduced projection optical lens 50, this defect can be more effectively suppressed by reducing the lens aperture. In addition, defects caused by laser irradiation of the reduced projection optical lens 50 can be suppressed to extend lifetime.

In this manner, particularly when the control unit 80 sets laser beam 1 at a fixed position, performs a sweep operation while synchronizing the mask 30 and the substrate stage 60 on which the substrate 70 is placed, and further has a temperature adjustment function for the reduced projection optical lens 50, laser ablation processing can be performed by using the reduced projection optical lens 50 having high accuracy with an NA of 0.12 or more and a laser beam having a high energy density of 1.0 mJ/cm² or more.

In addition, the ablation processing apparatus 100 illustrated in FIG. 2 may include a mask alignment camera 31 as image capturing means for reading a feature portion of the photomask 30, and an object-to-be-processed alignment camera 61 as image capturing means for reading a feature portion of the substrate 70. The mask alignment camera 31 may be configured to send position information of the feature portion of the photomask 30 to the control unit 80. The object-to-be-processed alignment camera 61 may be configured to send position information of the feature portion of the substrate 70 to the control unit 80. The control unit 80 may be configured to align the relative positions of the substrate 70 and the photomask 30 based on the position information. In another aspect, the control unit 80 may be configured to move the substrate 70 placed on the substrate stage 60 and the photomask 30 in synchronization.

### [Ablation Processing Method]

The ablation processing method of the present invention can be performed by using, for example, the ablation processing apparatus of the present invention, but may also be performed by using an apparatus other than the above-described ablation processing apparatus.

Hereinafter, an example of the ablation processing method of the present invention that can be performed by using the ablation processing apparatus 100 illustrated in FIG. 2 will be specifically described.

The ablation processing method of the present invention is an ablation processing method for forming a processed recessed portion on a surface of the substrate 70 through ablation processing using irradiation energy of laser beam 1. The ablation processing is performed such that an angle formed by the sidewall surface of the processed recessed portion on the opening side of the processed recessed portion and the surface of the substrate 70 is 80° or more and 90° or less. According to the ablation processing method of the present invention, high-density processed recessed portions such as VIAs and trenches can be formed in processing of a semiconductor package substrate or the like, and recessed-portion-forming processing with a high aspect ratio can be performed, and thus processed recessed portions such as deep VIAs and trenches can be formed. Accordingly, a semiconductor package substrate that enables densification and reduction in the resistance value of metal wiring embedded in the processed recessed portions and exhibits high performance can be manufactured.

In addition, in formation of processed recessed portions such as fine VIAs and trenches in semiconductor package processing, laser beam energy exceeding threshold energy required for ablation to reach an end portion of a processing bottom surface is preferably applied in order to stably perform processing in which an angle formed by a wall surface of a processed recessed portion with a laser beam and a plane along a surface of a substrate is close to vertical. For this reason, it is preferable to increase energy density when ablation processing with laser is performed. Thus, it is preferable to set energy density of laser beam 5 with which a processed portion of the substrate 70 is irradiated to 1.0 [J/cm²] or more. In this manner, it is possible to provide, more easily, a substrate for use in a semiconductor package substrate that enables densification and reduction in wiring resistance.

In addition, it is preferable to reduce the irradiation size of laser beam 4 by passing laser beam 4 through the reduced projection optical lens 50 having an NA of 0.12 or more. When the NA of the reduced projection optical lens is 0.12 or more, a laser beam having a high amount of energy can be applied to a processed portion of the substrate, processing with higher resolution can be stably performed, and thus stable recessed-portion processing by fine and high-aspect-ratio ablation processing can be performed. For this reason, it is possible to provide, more easily, a substrate for use in a semiconductor package substrate that enables densification and reduction in wiring resistance.

In addition, it is preferable to adjust the irradiation size of laser beam 3 by passing laser beam 3 through the mask 30, set laser beams 5 and 6 at fixed positions, sweep a laser beam relative to a pattern area of the mask by performing a sweep operation while synchronizing the mask 30 and the substrate stage 60, and perform ablation processing having a size larger than the irradiation sizes of laser beams 5 and 6, thereby forming a processed recessed portion. Processing by such laser irradiation is also referred to as scanning processing. In this manner, it is possible to provide, even more easily, a substrate for use in a semiconductor package substrate that enables densification and reduction in wiring resistance.

As described above, in the present invention, scanning processing is also effective in which processing is performed while laser beams 5 and 6 are scanned relative to a surface to be processed 71. By performing the scanning processing, laser processing can be performed with high accuracy even on a large-area substrate 70. In addition, by performing the scanning processing, an increase in processing time can be prevented even when the number of recessed portions and/or through-holes to be processed increases.

Laser processing can be performed without moving laser beams 1 to 6 by performing the scanning processing by moving the substrate 70 placed on the substrate stage 60 and the photomask 30 in synchronization.

In addition, in this aspect, since a processing region is not limited to an area of a lens, an area (angle of view) larger than the area of the lens can be processed.

According to this aspect, the reduced projection optical lens 50 necessary for irradiation can be made small, and laser irradiation positional accuracy and temperature controllability can also be improved. In addition, since the reduced projection optical lens 50 described below can be made small, image distortion caused by irradiation is also small.

In the ablation processing apparatus 100 illustrated in FIG. 2, when the substrate 70 placed on the substrate stage 60 and the photomask 30 are moved in synchronization by using the control unit 80, the relative positions of the substrate 70 and the photomask 30 can be aligned based on position information of a feature portion of the mask 30 acquired by the mask alignment camera 31 and position information of a feature portion of the substrate 70 acquired by the object-to-be-processed alignment camera 61.

In the ablation processing method of the present invention, processing is preferably performed with the intensity distribution of laser on a surface to be processed of the substrate 70 being an irradiation shape in which the intensity of an outer portion in the intensity distribution is higher than the intensity of an inner portion. Such an ablation processing method will be described by way of example with reference to FIGS. 2 to 5.

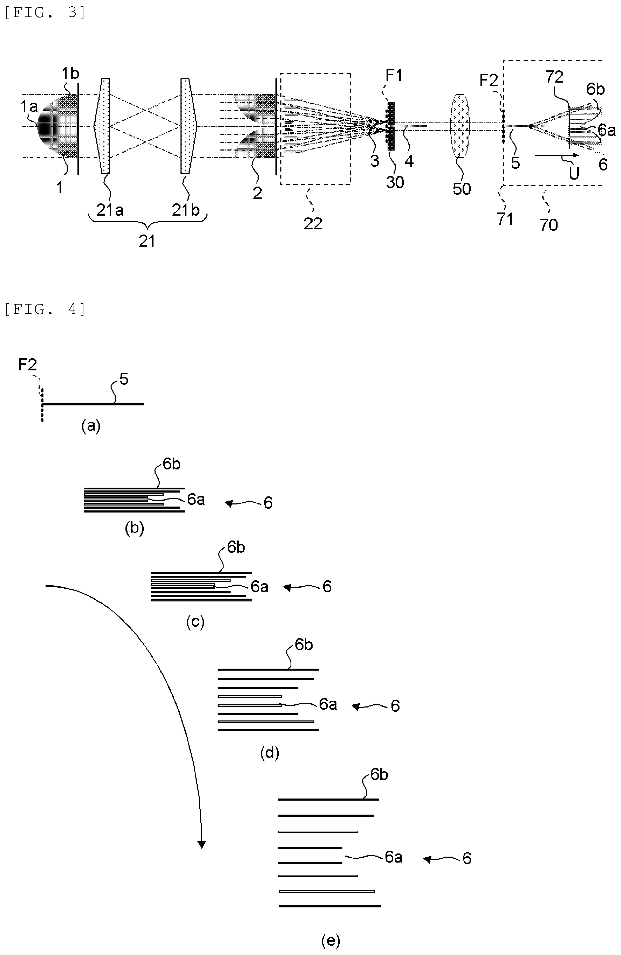

First, as illustrated in FIG. 2, the laser light source 10 oscillates laser beam 1 having an irradiation shape illustrated in FIG. 2(a). As illustrated in FIG. 3, the irradiation shape of laser beam 1 in this example is the irradiation shape of laser in which the laser intensity of the inner portion 1a is higher than the laser intensity of the outer portion 1b. In another aspect, the irradiation shape of laser beam 1 has an intensity distribution in which the laser intensity of the center (inner portion) 1a is highest and the laser intensity of the skirt (outer portion) 1b is low.

Subsequently, laser beam 1 is incident on the prism 21 of the first optical function unit 20. The prism 21 is a prism that converts laser beam 1 into laser beam 2 having an irradiation shape (FIG. 2(b)) in which the intensity of an outer portion in the intensity distribution of laser beam 1 is higher than the intensity of an inner portion. In FIG. 2, the prism 21 including four (two pairs of) roof prisms is illustrated as an example of the prism 21. Note that, in FIG. 3, only two roof prisms 21a and 21b related to the irradiation shape of laser beam 1 along a plane parallel to the sheet are representatively illustrated. Note that the prism 21 is not limited to roof prisms and may be, for example, a prism including conical prisms.

Subsequently, laser beam 2 emitted from the prism 21 and having the irradiation shape illustrated in FIGS. 2(b) and 3 is incident on the shaping optical system 22. As illustrated in FIG. 3, the shaping optical system 22 condenses each component of laser beam 2 toward an image formation point F1, shapes the irradiation shape of laser beam 2 into the top-hat irradiation shape illustrated in FIG. 2(c), and forms laser beam 3.

Laser beam 3 is incident on the photomask 30 located at the position of the image formation point F1. The photomask 30 has a mask pattern corresponding to a pattern to be processed on the substrate 70. A recessed portion and/or a through-hole can be formed in the substrate 70 in a desired pattern by performing scanning irradiation with the laser beam on the substrate 70 through the photomask 30.

Laser beam 4 emitted from the photomask 30 and having the irradiation shape (top-hat shape) illustrated in FIG. 2(d) has a direction converted by the folding mirror 40 and is incident on the reduced projection optical lens (projection lens) 50. Effects obtained by using the optional reduced projection optical lens 50 will be described later.

As illustrated in FIG. 3, laser beam 5 emitted from the reduced projection optical lens 50 reaches the surface (initial surface to be processed) 71 of the substrate 70. FIG. 3 illustrates an example in which an image formation point F2 of the reduced projection optical lens 50 is aligned with the surface 71 of the substrate 70. However, the image formation point F2 of the reduced projection optical lens 50 is not limited to the surface 71 of the substrate 70.

As illustrated in FIG. 3, the irradiation shape of laser beam 5 with which the surface 71 of the substrate 70 is irradiated is a top-hat type as illustrated in FIGS. 2(e) and 3. On the other hand, on a surface to be processed 72 on which processing has progressed further from the image formation point F2, as illustrated in FIG. 3, processing is performed with the intensity distribution of laser beam 6 being an irradiation shape in which the intensity of an outer portion 6b in the intensity distribution is higher than the intensity of an inner portion 6a.

In the examples illustrated in FIGS. 2 and 3, as schematically illustrated in FIGS. 4(a) to 4(e), the irradiation shape of laser beam 6 becomes closer to the irradiation shape of laser beam 2 before shaping by the shaping optical system 22 as the position becomes farther from the image formation point F2 (under-focus U). This is the reason why the intensity distribution of laser beam 6 is such that the intensity of the outer portion 6b in the intensity distribution is higher than the intensity of the inner portion 6a.

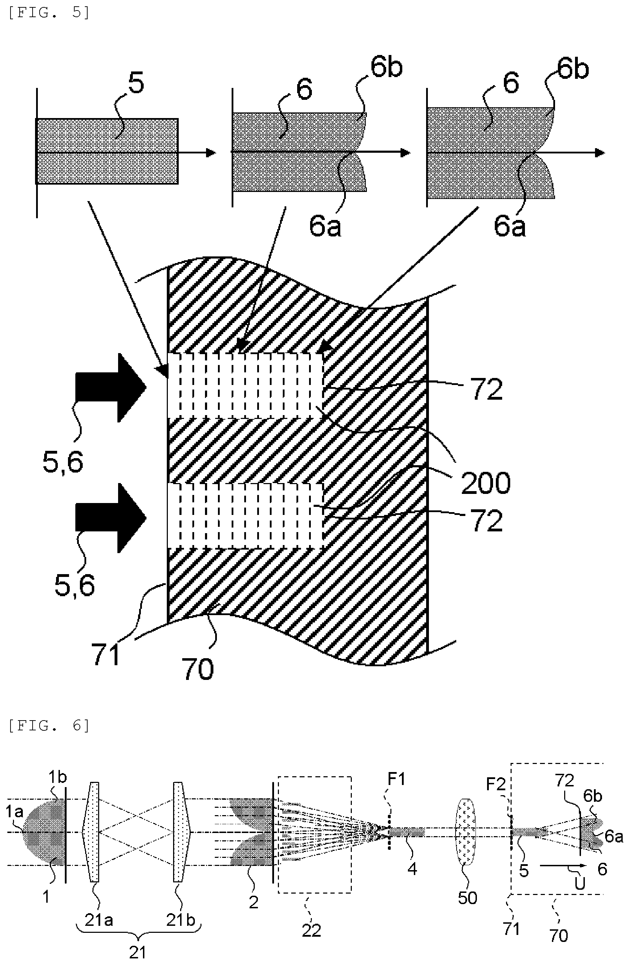

In the ablation processing method of the present invention, processing is performed on the surface to be processed 72 with the intensity distribution of laser beam 6 being an irradiation shape in which the intensity of the outer portion 6b in the intensity distribution is higher than the intensity of the inner portion 6a, thereby making it possible to more effectively and stably suppress the recessed portion 200 to be formed from having a tapered shape as schematically illustrated in FIG. 5. By continuing the processing, a through-hole in which tapering is stably suppressed can be formed. Thus, an angle formed by a sidewall surface of the processed recessed portion on an opening side of the processed recessed portion and the surface of the substrate can be stably set to 80° or more and 90° or less. In addition, in the ablation processing method of the present invention, since a processed recessed portion formed in this manner can be more effectively and stably suppressed from having a tapered shape, a high-definition and complex pattern can be formed. In addition, according to the ablation processing method of the present invention, even when a processed recessed portion is formed at high resolution, the recessed portion 200 to be formed can be more effectively and stably suppressed from having a tapered shape.

In the ablation processing method of the present invention, processing is more preferably performed on at least part of the surface to be processed 72 of the substrate 70 with laser having an irradiation shape in which the intensity of the outer portion 6b is higher than the intensity of the inner portion 6a. For example, as in the examples illustrated in FIGS. 2 and 3, processing may be performed on the surface (initial surface to be processed) 71 of the substrate 70 with laser beam 5 having a top-hat irradiation shape.

In the present invention, for example, as illustrated in FIG. 5, processing can be performed while changing the shape of the intensity distribution of laser beam 6 on the surface to be processed 72 of the substrate 70 as processing proceeds in the depth direction of the substrate 70.

The example illustrated in FIG. 5 can be regarded, in another aspect, as an example in which processing is performed while the shape of the intensity distribution of laser beam 6 is changed such that the intensity of the outer portion 6b in the intensity distribution of laser beam 6 becomes higher than the intensity of the inner portion 6a as processing proceeds in the depth direction of the substrate 70.

By performing processing in this manner, a processed recessed portion to be formed can be more reliably suppressed from having a tapered shape, and by extension, a high-definition and complex pattern can be more reliably formed.

Note that, when processing is performed with the intensity distribution of laser beam 6 on at least one surface to be processed 72 of the substrate 70 being an irradiation shape in which the intensity of the outer portion 6a in the intensity distribution is higher than the intensity of the inner portion 6b, the laser intensity distribution does not need to be continuously changed.

In the present invention, the mask 30 may be used to forming a predetermined processed recessed portion with patterning. Even when the mask 30 is used, a processed recessed portion (including a through-hole) to be formed can be effectively suppressed from having a tapered shape by performing processing with the intensity distribution of laser beam 6 on the surface to be processed 72 of the substrate 70 being an irradiation shape in which the intensity of the outer portion 6b in the intensity distribution is higher than the intensity of the inner portion 6a, and by extension, a high-definition and complex pattern can be reliably formed. Alternatively, as illustrated in FIG. 5, the mask 30 does not need to be used in the present invention.

The example described above with reference to FIGS. 2 to 5 can be regarded, in another aspect, as an ablation processing method for forming a processed recessed portion on the substrate 70 by using a laser beam, the ablation processing method using the first optical function unit 20 that shapes the irradiation shape of laser beam 2, which is a shape in which the intensity of an outer portion in the intensity distribution of the laser beam is higher than the intensity of an inner portion, into a top-hat irradiation shape.

By laser-processing the substrate 70 by using the first optical function unit 20 as described above, processing in at least part of the substrate 70 away from the surface can be performed with the irradiation shape of laser beam 6, which is a shape in which the intensity of the outer portion 6b is higher than the intensity of the inner portion 6a. With the ablation processing method, even when a processed recessed portion is formed at high resolution, the width of a bottom portion of the recessed portion can be more reliably and stably suppressed from becoming smaller than the width of an opening portion of the recessed portion at the initial processing surface 71. In addition, with the ablation processing method, even when a through-hole is formed at high resolution, the width of a lower-end opening portion of the through-hole can be more reliably and stably suppressed from becoming smaller than the width of an upper end portion of the through-hole. In other words, in the ablation processing method of the present invention expressed in this aspect, even when a processed recessed portion is formed at high resolution, the processed recessed portion to be formed can be more reliably and stably suppressed from having a tapered shape, and by extension, a high-definition and complex pattern can be formed.

The substrate 70, which is an object to be subject to laser processing in the present invention, is not particularly limited, and for example, a semiconductor package substrate may be used as the substrate 70.

Particularly in processing of a semiconductor package substrate, there is a processing pattern in which processed recessed portions, for example, VIA processing and groove processing, are mixed. In this case, processing can be performed in the same process by the method of the present invention without separating the processes of VIA processing and groove processing. In addition, semiconductor package substrates have become denser, and in a laser drilling method in VIA processing, processing time increases due to an increase in the number of holes to be processed along with densification, but the present method does not cause an increase in processing time due to an increase in the number of holes to be processed and an increase in pattern definition.

According to the present invention, as described above, a high-definition pattern of a processed recessed portion can be formed. Specifically, according to the present invention, for example, a processed recessed portion having a width of 20 µm or less and having suppressed tapering can be formed.

In addition, a processed recessed portion that can be formed according to the present invention may have, for example, a depth of 20 µm or less. Note that a bottomed recessed portion can be formed when the processing depth is less than the thickness of the substrate 70, and a through-hole can be formed when the processing depth is the same as the thickness of the substrate 70.

In another aspect, according to the present invention, a pattern of a processed recessed portion having a high aspect ratio can be formed. According to the present invention, for example, a processed recessed portion in which the ratio of the height of a processed portion to the width of a bottom portion of the recessed portion is 1.0 or more can be formed. In addition, according to the present invention, for example, a processed recessed portion in which the ratio of the height of a processed portion to the width of a lower-end opening portion of a through-hole is 1.0 or more can be formed.

In still another aspect, according to the present invention, for example, a recessed portion in which the width of a bottom portion of the recessed portion is 70% or more of the opening width of the recessed portion at an initial processing surface of an object to be processed, and/or a through-hole in which the width of a lower-end opening portion of the through-hole is 70% or more of the width of an upper-end opening portion of the through-hole at an initial processing surface of an object to be processed can be formed.

In addition, in the present invention, since a recessed portion can be formed while tapering is suppressed, a plurality of recessed portions 200 can be formed as illustrated in FIG. 7, and a distance 202 between bottom portions of adjacent recessed portions 200 can be 110% or less of a width 201 of the bottom portion. Thus, in the present invention, the plurality of recessed portions 200 can be formed at high density.

As described above, the ablation processing method of the present invention can form a high-definition and complex pattern. Thus, with a substrate manufacturing method of the present invention, including the ablation processing method of the present invention, a substrate having a high-definition and complex pattern can be manufactured.

The present description includes the following embodiments.

[Claim 1] An ablation processing method for forming a processed recessed portion on a surface of a substrate through ablation processing using irradiation energy of a laser beam,
wherein the ablation processing is performed such that an angle formed by a sidewall surface of the processed recessed portion on an opening side of the processed recessed portion and the surface of the substrate is 80° or more and 90° or less.

[2] The ablation processing method of the above [1], wherein energy density of the laser beam with which a processed portion of the substrate is irradiated is set to 1.0 [J/cm²] or more.

[3] The ablation processing method of the above [1] or [2], wherein an irradiation size of the laser beam is reduced by passing the laser beam through a reduced projection optical lens having an NA of 0.12 or more.

[4] The ablation processing method of any one of the above [1] to [3], wherein an irradiation size of the laser beam is adjusted by passing the laser beam through a mask, the laser beam is set at a fixed position, the laser beam is swept relative to a pattern area of the mask by performing a sweep operation while synchronizing the mask and a substrate stage on which the substrate is placed, and ablation processing having a size larger than the irradiation size of the laser beam is performed, thereby forming the processed recessed portion.

[5] An ablation processing apparatus for forming a processed recessed portion on a surface of a substrate through ablation processing using irradiation energy of a laser beam, the ablation processing apparatus comprising:
a first optical function unit including a laser light source that irradiates the laser beam;
a substrate stage on which the substrate is placed; and
a control unit that controls the ablation processing apparatus,
wherein the control unit controls execution of the ablation processing such that an angle formed by a sidewall surface of the processed recessed portion on an opening side of the processed recessed portion and the surface of the substrate is 80° or more and 90° or less.

[6] The ablation processing apparatus of the above [5], wherein the control unit sets energy density of the laser beam with which a processed portion of the substrate is irradiated to 1.0 [J/cm²] or more.

[7] The ablation processing apparatus of the above [5] or [6], further comprising a reduced projection optical lens having an NA of 0.12 or more, wherein an irradiation size of the laser beam is reduced by passing the laser beam through the reduced projection optical lens.

[8] The ablation processing apparatus of any one of the above [5] to [7], further comprising a mask that adjusts a beam shape of the laser beam when the laser beam passes through the mask,
wherein the control unit sets the laser beam at a fixed position, sweeps the laser beam relative to a pattern area of the mask by performing a sweep operation while synchronizing the mask and the substrate stage, and performs ablation processing having a size larger than the irradiation size of the laser beam, thereby forming the processed recessed portion.

[9] A substrate for use in a semiconductor package substrate, wherein
the substrate has at least one recessed portion on a surface of the substrate, and
an angle formed by a sidewall surface of the recessed portion on an opening side of the recessed portion and the surface of the substrate is 80° or more and 90° or less.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. An ablation processing method for forming a processed recessed portion on a surface of a substrate through ablation processing using irradiation energy of a laser beam,
wherein the ablation processing is performed such that an angle formed by a sidewall surface of the processed recessed portion on an opening side of the processed recessed portion and the surface of the substrate is 80° or more and 90° or less.

2. The ablation processing method according to claim 1, wherein energy density of the laser beam with which a processed portion of the substrate is irradiated is set to 1.0 [J/cm²] or more.

3. The ablation processing method according to claim 1, wherein an irradiation size of the laser beam is reduced by passing the laser beam through a reduced projection optical lens having an NA of 0.12 or more.

4. The ablation processing method according to any one of claims 1 to 3, wherein an irradiation size of the laser beam is adjusted by passing the laser beam through a mask, the laser beam is set at a fixed position, the laser beam is swept relative to a pattern area of the mask by performing a sweep operation while synchronizing the mask and a substrate stage on which the substrate is placed, and ablation processing having a size larger than the irradiation size of the laser beam is performed, thereby forming the processed recessed portion.

5. An ablation processing apparatus for forming a processed recessed portion on a surface of a substrate through ablation processing using irradiation energy of a laser beam, the ablation processing apparatus comprising:
a first optical function unit including a laser light source that irradiates the laser beam;
a substrate stage on which the substrate is placed; and
a control unit that controls the ablation processing apparatus,
wherein the control unit controls execution of the ablation processing such that an angle formed by a sidewall surface of the processed recessed portion on an opening side of the processed recessed portion and the surface of the substrate is 80° or more and 90° or less.

6. The ablation processing apparatus according to claim 5, wherein the control unit sets energy density of the laser beam with which a processed portion of the substrate is irradiated to 1.0 [J/cm²] or more.

7. The ablation processing apparatus according to claim 5, further comprising a reduced projection optical lens having an NA of 0.12 or more, wherein an irradiation size of the laser beam is reduced by passing the laser beam through the reduced projection optical lens.

8. The ablation processing apparatus according to any one of claims 5 to 7, further comprising a mask that adjusts a beam shape of the laser beam when the laser beam passes through the mask,
wherein the control unit sets the laser beam at a fixed position, sweeps the laser beam relative to a pattern area of the mask by performing a sweep operation while synchronizing the mask and the substrate stage, and performs ablation processing having a size larger than the irradiation size of the laser beam, thereby forming the processed recessed portion.

9. A substrate for use in a semiconductor package substrate, wherein
the substrate has at least one recessed portion on a surface of the substrate, and
an angle formed by a sidewall surface of the recessed portion on an opening side of the recessed portion and the surface of the substrate is 80° or more and 90° or less.
